# EUROPEAN PATENT SPECIFICATION

(11) **EP 2 128 303 B1**
(45) Date of publication and mention of the grant of the patent: **13.03.2013**
(21) Application number: 08009926.0
(22) Date of filing: 30.05.2008
(51) Int. Cl.: C23C 14/24

(54) **Arrangement for coating a substrate**
Anordnung zur Beschichtung eines Substrats
Agencement pour le revêtement d'un substrat

(43) Date of publication of application: 02.12.2009
(73) Proprietor: Applied Materials, Inc., Santa Clara, CA 95054 (US)
(72) Inventor: Bangert, Stefan, 36396 Steinau (DE); Dieguez-Campo, Jose Manuel, 63457 Hanau (DE); König, Michael, 60529 Frankfurt am Main (DE); Krishna, Nety M., Sunnyvale, CA 94087 (US); Kwak, Byung-Sung Leo, Portland, OR 97229 (US)
(74) Representative: Zimmermann & Partner

(56) References cited:
- EP-A- 1 584 705
- DE-A1- 10 224 908
- US-A- 4 401 052
- US-A- 5 522 955
- MARTIN M ET AL: "A multilayer semi-industrial vacuum deposition equipment for producing ultrathin batteries" THIN SOLID FILMS, ELSEVIER-SEQUOIA S.A. LAUSANNE, CH, vol. 398-399, 1 November 2001 (2001-11-01), pages 572-574, XP004328737 ISSN: 0040-6090
- LIU ET AL: "A sequential thin-film deposition equipment for in-situ fabricating all-solid-state thin film lithium batteries" THIN SOLID FILMS, ELSEVIER-SEQUOIA S.A. LAUSANNE, CH, vol. 515, no. 7-8, 15 February 2007 (2007-02-15), pages 4045-4048, XP005890836 ISSN: 0040-6090

## Description

The invention relates to an arrangement for coating a substrate according to the preamble of patent claim 1.

Arrangements for coating a substrate with cadmium sulfide or zinc cadmium sulfide or with OLED substances are already known (US 4 401 052, DE 102 24 908 A1, EP 1 357 200 A1). Herein the materials with which the substrate is to be coated are vaporized in vaporizers,

With these arrangements, however, no materials are vaporized which belong to the group alkali- and/or alkaline earth-metals, because these metals are highly reactive and form compounds with glass and water. Of the alkali- and alkaline earth-metals, lithium is in particular of interest since it is suitable for the production of only extremely slowly discharging batteries and accumulators.

Modern lithium batteries came first on the market in 1991. With them, Li⁺ ions are exchanged between a graphite (LiₓC₆) anode and a layered oxide (Li₁₋ₓ T^{M}O₂) cathode, T^{M} being a transition metal - cobalt, nickel or occasionally manganese. At an average voltage of 3.8 V the energy density is approximately 180 Whkg⁻¹, which is approximately the fivefold of the considerably older lead-acid battery.

The most recent developments in the field of Li⁺ batteries involve the use of nanomaterials. Moreover, lithium-oxygen batteries are being investigated, which comprise an oxygen cathode and a lithium anode (M. Armand and J.-M. Tarascon: Building Better Batteries, Nature, Vol. 451, 7 Febr. 2008, pp. 652 - 657).

Lithium batteries are also produced as thin-layer batteries (WO 02/099910 A1, p. 1, lines 17 - 20). The application of the thin layers takes place by sputtering. During the sputtering, ions, for example of lithium orthophosphate, are deposited on a substrate. Through reactive spluttering an electrolyte layer of LiₓP_{y}ON_{z} can be applied.

It is also known to apply thin layers of SiO₂ and lithium by means of PECVD (= Plasma Enhanced Chemical Vapor Deposition) onto a substrate (US 6 177 142 B1).

Further known is the coating of a substrate with Li-Co-O, wherein an electron beam vaporizer is being utilized (JP-2003 234100).

In another known arrangement for the production of thin layers of lithium or lithium alloys on a substrate, lithium, located in a crucible, is vaporized under vacuum (JP 2002 206160).

As another example, EP 1 584 705 A describes a film formation source for use in a film formation apparatus having a film formation chamber in which a vacuum or a depressurized state is formed and a sublimated or evaporated film formation material is formed into a film on a substrate, said film formation source includes a discharge outlet disposed within the film formation chamber for discharging the film formation material towards a film formation surface of the substrate, a material accommodating section disposed outside the film formation chamber and including a material container containing the film formation material; a heating device for heating the film formation material contained in the material container; a discharge passage air-tightly communicating the discharge outlet with the material accommodating section, an escape passage branching from the discharge passage for diverting the film formation material moving towards the discharge outlet to a different direction, and flow restricting devices provided at least on the lower stream side of a branching position of the discharge passage and on the escape passage for stopping/passing or variably adjusting the flow of the film formation material. If the material container 12A is disconnected from the discharge passage and a gate valve is closed, it is allowed to open the material accommodating section to the surrounding atmosphere to remove or exchange the material container, without bringing about any change in the atmosphere within the film formation chamber.

The invention addresses the problem of providing in arrangement for coating a substrate, wherein the coating material can also be a member of the group of chemically reactive alkali- and alkaline earth-metals.

This problem is solved according to the characteristics of patent claim 1.

The advantage attained with the invention comprises in particular that a vaporizer crucible can readily be replenished or exchanged free of risks. This is of significance in particular for highly reactive materials to be vaporized, for example lithium, since these must not be contacted nor be exposed to normal atmosphere, oxygen or water.

According to one embodiment, an arrangement for the coating of a substrate by means of a vapor distributor connectable via an inlet with a vapor crucible is provided, wherein between the crucible and inlet at least one valve is disposed, wherein the vaporizer crucible is located in a chamber that can be evacuated or flooded by means of a vacuum valve, wherein a second valve is provided that is associated with the crucible chamber.

According to another embodiment, a method for the production of coated substrates with an arrangement is provided. Therein, the arrangement for the coating of a substrate by means of a vapor distributor connectable via an inlet with a vapor crucible is provided, wherein between the crucible and inlet at least one valve is disposed, wherein the vaporizer crucible is located in a chamber that can be evacuated or flooded by means of a vacuum valve, wherein a second valve is provided that is associated with the crucible chamber.

According to yet another embodiment, a method for the production of a lithium battery using an arrangement for the coating of a substrate by means of a vapor distributor connectable via an inlet with a vapor crucible, wherein between the crucible and inlet at least one valve is disposed, wherein the vaporizer crucible is located in a chamber that can be evacuated or flooded by means of a vacuum valve.

Embodiment examples of the invention are shown in the Figures and will be described in further detail in the following. The drawing depict:
- Fig. 1: a vapor feed system with the separating value closed.
- Fig. 2: the vapor feed system according to Figure 1 with a PID controller with the separating valve open,
- Fig. 3: a vapor feed system with two separating valves,
- Fig. 4: the vapor feed system according to Figure 3, in which the separating valves are closed and a vaporizer crucible is laterally shifted.

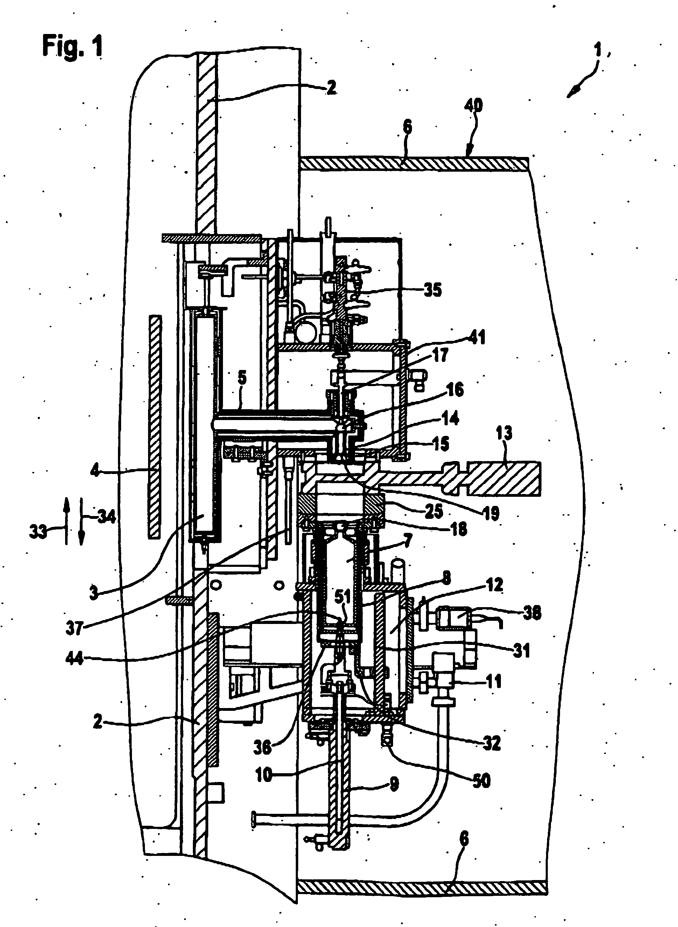

Figure 1 shows a vapor feed system 1 for a vacuum chamber. Of the vacuum chamber, only the chamber wall 2 is evident. In Figures 1 to 3 of DE 102 24 908 A1 such a vacuum chamber is shown in detail.

The vapor feed system 1 comprises a vertically oriented vaporizer tube 3, opposite to which is disposed a substrate 4 to be coated. The vaporizer tube 3, which is provided with several linearly vertically disposed vaporizer nozzles, is connected with an inlet tube 5 which is directed at right angles to the vaporizer tube 3. This vaporizer tube 3, consequently, serves as a vapor distributor. Parallel to the vaporizer tube 3 and perpendicular to the inlet tube 5 a cylindrical vaporizer crucible 7 is provided, which is located in a crucible housing 8. If reactive materials, for example lithium, are vaporized, the crucible 7 is, for example, comprised of stainless steel, titanium or molybdenum-beneath the vaporizer crucible 7 is located a cylinder 9 with a piston 10. The vaporizer crucible 7, which in Figure 1 is in its lower position, can be raised and lowered by means of the piston 10. Provided laterally to the piston 10 is a vacuum valve 11, via which a crucible chamber 12 can be evacuated or be flooded, for example with protective gas.

However, since not only the crucible 7 is exposed to the reactive material, it is obvious that the entire vapor feed system must be comprised of a material that is inert relative to these reactive materials.

Located with in this crucible chamber 12 is a linear guide 31 which contributes to the stabilization of the crucible chamber 12. Disposed on this linear guide 31 is a guide element 32 that is connected to the vaporizer crucible 7. By moving the guide element 32 along the linear guide 31 the vaporizer crucible 7 is also moved along the linear guide 31, *i.e.* in the direction of arrows 33 and 34.

With the aid of a separating valve 13, shown in Figure 1 in the closed state, the crucible chamber 12 together with the crucible 7 can be separated from the inlet tube 5. This separating valve 13 is disposed on a spacer ring 25. The inlet tube 5 includes a downwardly directed connection fitting 14. In Figure 1 a heating jacket 15 can further be seen. The connection fitting 14 can be closed by means of an end piece 16 of a piston 17. This connection fitting 14 comprises furthermore a calotte-shaped part 19 into which the upper part 18 of the vaporizer crucible 7 can engage. Piston 17 is connected with a cylinder by means of which the piston 17 can be moved. The cylinder 35 can be a pneumatically operated cylinder.

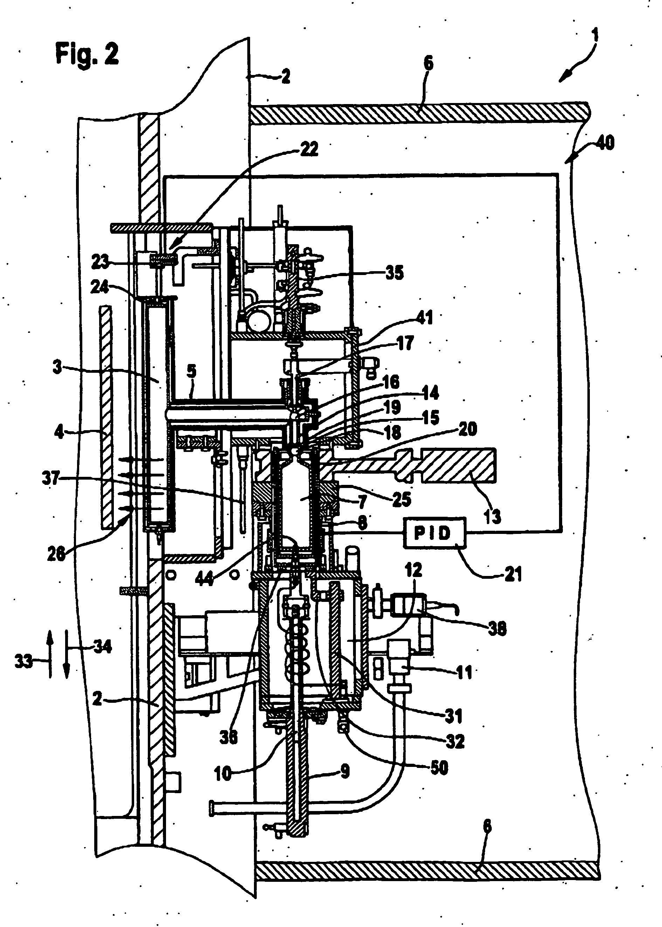

Within the crucible chamber 12 a holding arrangement 36 that is placed onto the piston 10 is further evident. A thermocouple 44 is wound from a vacuum-tight power feed through 50 in a spiral about the holding arrangement 36 and terminates in an indentation 51 located in the bottom of crucible 7. By means of the thermocouple 44 the temperature at the bottom of the vaporizer crucible 7 can be measured. The spiral winding of the thermocouple 44, that, on the one hand, is fastened on the power feed through 50 and, on the other hand, on the holding arrangement 36, permits the necessary lift of crucible 7 from a lower into an upper position. This is illustrated in Figure 2. Therewith the thermocouple 44 can be moved In the direction of arrows 33 and 34, respectively, by means of piston 10.

Also evident in Figure 1 is a wall 6 of a glovebox 40, which encompasses the vaporizer crucible 7 and the vaporizer chamber 12: It becomes thereby possible to exchange the vaporizer crucible 7 under protective gas or to fill it with material. As protective gas can servo, for example, argon. Figure 1 shows the glovebox 40 only segment-wise and schematically.

Figure 1 shows further a pressure gauge head 38 for measuring the pressure in the vaporizer crucible 7. When the pressure in the vaporizer crucible 7 reaches the desired value, the separating valve 13 is either opened or closed by means of a control not depicted in Figure 1.

evident is also a cooling means port 37, in Figure 1 shown only as a segment. This cooling means port 37 is connected with a supply unit, not shown in Figure 1, for a cooling means, for example H₂O. If needed, the housing 41 is cooled with this cooling means. The cooling means port 37 can be connected to the supply unit via an element, for example a tubing of rubber, not shown in Figure 1. If the cooling means is H₂O, the supply unit can be a conventional water connection.

Figure 2 shows the same arrangement as Figure 1, wherein, however, the vaporizer crucible 7 is raised by the piston 10 and specifically so far that the uppermost part 18 of vaporizer crucible 7 is inserted into the lowermost part 19 of connection fitting 14. The upper part 18 of the vaporizer crucible 7 is here formed spherically while the lower part of connection fitting 14 is implemented in the form of a calotte. The separating valve 13 is opened herein.

Denoted by 20 is a crucible system that encompasses the vaporizer crucible 7.

This crucible heating system 20 is connected with a PID controller 21 which, in turn, is connected with a rate acquisition 22. This rate acquisition 22 can be provided with a measuring instrument 23, for example an oscillating crystal or an emission spectroscope. This measuring instrument 23 acquires the vaporization rate of the material which reaches the substrate 4 from the vaporizer tube 3. For this purpose in the vaporizer tube 3 a special nozzle 24 is provided which generates a rate signal that is proportional to the coating rate on the substrate 4. Through this nozzle 24 streams the vapor onto the measuring instrument 23. In this manner, the crucible heating system 20 can be regulated as a function of the coating rate. On the PID controller 21 a nominal value can also be set . Instead of a PID controller, another controller can also be provided. The PID controller involves the general basic type of a controller comprised of the parallel circuit of PD controllers and I controllers, whose properties - early detection of disturbances, rapid correction and elimination of regulation deviation - it combines. If the regulated process contains dead times, the PID controller cannot be utilized due to its D component.

The vapor exiting the vaporizer tube 3 through the perpendicularly linearly disposed holes is shown symbolically by arrows 26. The holes are laid out such that high vaporization rates and uniform coating are attained. For example, they have a diameter of 1 mm to 4 mm and a distance of 5 mm to 30 mm. To compensate the layer thickness decreases in the margin regions of substrate 4, the holes or nozzle bores can here be located more closely to one another and, for example, only have half the distance from one another. Instead of cylindrical holes, elongated holes or other forms of openings are also conceivable.

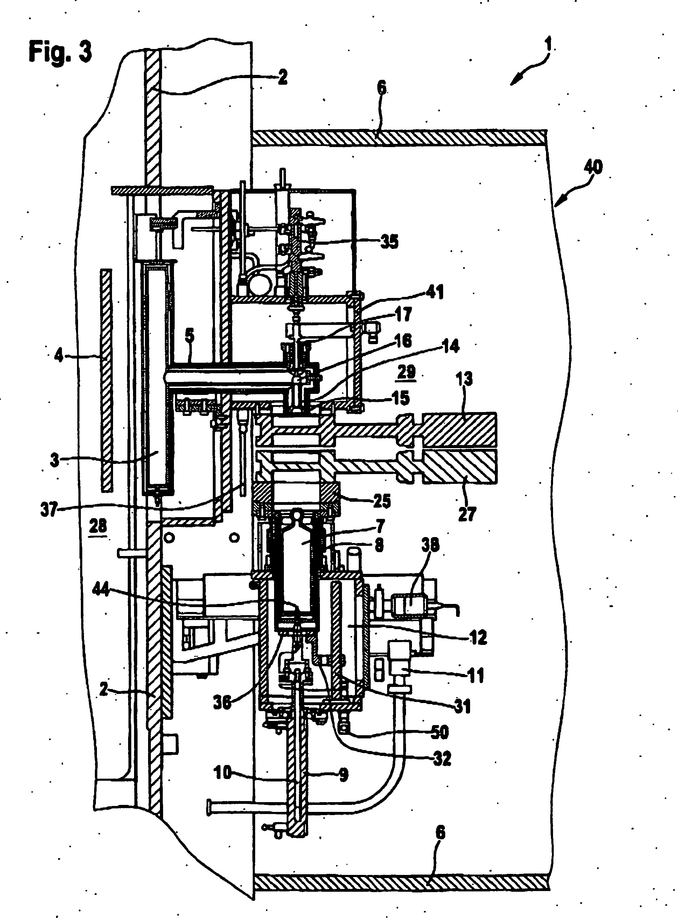

Figure 3 shows the same arrangement as Figure 1, however, with two separating valves 13 and 27, both of which are closed. The two separating valves 13 and 27 permit an even better exchange of the vaporizer crucible 7 under protective gas. The upper separating valve 13 separates the coating chamber 28 from atmospheric pressure 29, while the lower separating valve 27 separates the crucible chamber 8, fillable with protective gas, from atmospheric pressure 29. This separating valve 27 is disposed on the spacer ring 25.

The housing of the separating valve 27 must be implemented such that it is vacuum tight, however, the gate of the valve only needs to be diffusion-tight against gases. Since after flooding of crucible 7 to atmospheric pressure, no pressure difference with respect to the ambient air exists, the gate of the valve 27 does not need to absorb any vacuum forces.

In the representation of Figure 3 the vaporizer crucible 7 is located in its lower position. Via the vacuum valve 11, the crucible chamber 12 can be separately evacuated or flooded, for example with a protective gas. Not shown is the connection of the vacuum valve 11 to a gas supply and a vacuum pump. The gas supply as well as the vacuum pump can optionally be connected via, for example, a T-piece and appropriately disposed valves with the flexible corrugated tubing leading to the valve 11. For removing the vaporizer crucible 7 from the crucible chamber 12, the chamber is flooded. In the glovebox 40 the vaporizer crucible 7 can be refilled or exchanged, respectively. The glovebox 40 is herein under protective gas, for example argon.

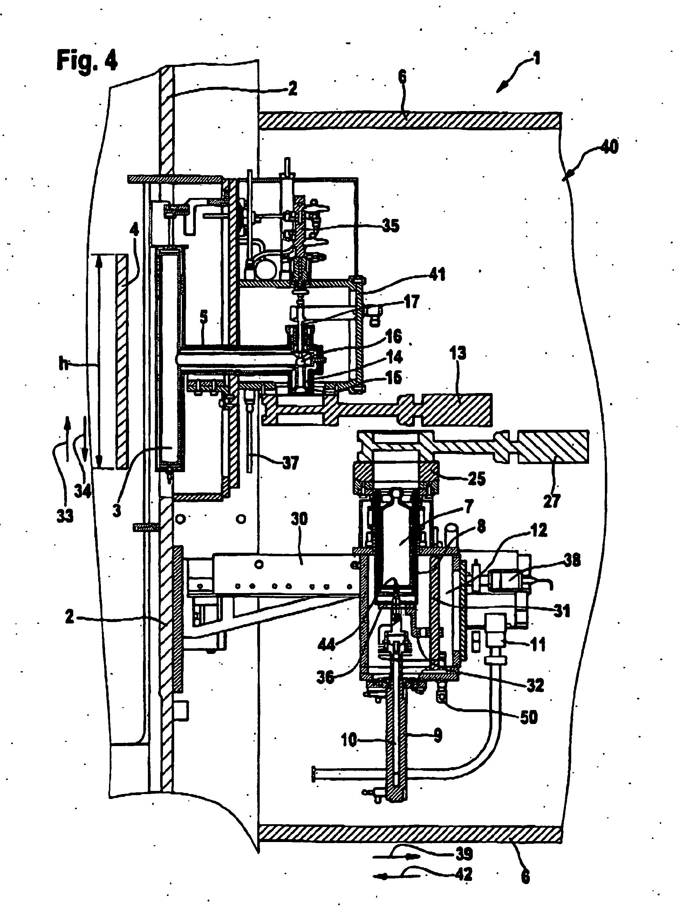

In the depiction of Figure 4 the vaporizer crucible 7 is brought along a rail 30 into a position remote from the vaporization chamber. This takes place by movement of the vaporizer chamber 12 in the direction of arrow 39. Preferably the vaporizer crucible 7 is exchanged or refilled in this position. The upper separating valve 13 is herein closed such that the vaporizer chamber continues to be under vacuum. Herewith the vacuum is not broken.

It is understood that exchanging the crucible 7, or also filling it, is only possible with the valve 27 open. The vaporizer crucible 7 must therefore be encompassed by the glovebox 40 filled with the protective gas.

As is shown in Figure 4, the vaporizer crucible 7 is located in its lower position. Via the vacuum valve 11 the crucible chamber 12 can be evacuated or flooded independently of the vacuum chamber. The vaporizer crucible 7, together with the crucible chamber 12, is introduced into the glovebox 40. Here the vaporizer crucible 7 is removed and replaced by a new vaporizer crucible or is refilled.

After filling the crucible 7 with the vaporization material, the separating valve 27 is closed and the crucible chamber 12 is evacuated. Subsequently crucible chamber 12 and vaporizer crucible 7 move along rail 30 back into their rearward position by moving in the direction of arrow 42. After the separating valves 13 and 27 have been connected vacuum-tight with one another and the crucible chamber 12 has been evacuated, the separating valves 13, 27 can be opened. The vaporizer crucible 7 is subsequently brought into the upper position by movement in the direction of arrow 33.

According to a further embodiment example, which is not depicted, the glovebox 40 can be located spaced apart from the coating installation. In this case the crucible 7 under protective gas is removed with the valve 27 closed in the pulled-out position shown in Figure 4 from the crucible chamber 12 together with the spacer ring 25 and a suitable, also not shown, locking mechanism, *i*.*e*. lifted from the rail 30. This locking mechanism fixes the crucible 7 on the spacer ring 25 or on the flange fastened on spacer ring 25. In this manner the crucible 7 in the closed state can be transported to the glovebox 40 located apart. Here the crucible 7 can optionally be cleaned, refilled again and closed with valve 27.

The above described processes can be utilized for the coating of glass substrates. However, using them, it is also possible to coat silicon wafers of 200 mm or 300 mm diameter, wherein a substrate carrier can be equipped with one or with several wafers. A substrate carrier is, however, not shown in Figure 4. The necessary coatable substrate height h for the uniform coating of all substrates placed onto the carrier, can be adapted via the length of the vaporizer tube 3.

Moreover, flexible substrates of synthetic material or metal can also be worked in an installation, such as for example depicted in Figure 3 of EP 1 589 130. In this known installation only the vapor distributor tube and the vapor exit nozzle would need to be disposed horizontally and parallel to the sheeting.

It is understood that, instead of one crucible, several crucibles can also be provided and be interconnected in the manner described in EP 1 357 200 A1.

## Claims

1. Arrangement for the coating of a substrate (4) by means of a vapor distributor (3) connectable via an inlet (5) with a vaporizer crucible (7), wherein between the crucible (7) and inlet (5) at least one valve (13) is disposed, wherein the vaporizer crucible (7) is located in a chamber (12) that can be evacuated or flooded by means of a vacuum valve (11), and **characterized by** a second valve (27) that is associated with the crucible chamber (12).

2. Arrangement as claimed in claim 1, **characterized in that** the vapor distributor (3) is a linear vapor distributor.

3. Arrangement as claimed in claim 1, **characterized in that** the vaporizer crucible (7) is movable toward the inlet (5) and away from it.

4. Arrangement as claimed in claim 1, **characterized in that** the valve (13) provided between crucible (7) and inlet (5) is associated with the inlet (5).

5. Arrangement as claimed in claim 1, **characterized in that** the second valve (27) is movable together with the vaporizer crucible (7) and the chamber (12).

6. Arrangement as claimed in claim 1, **characterized in that** a measuring instrument (23) is provided which measures the vaporization rate and that this measuring instrument (23) is connected with a regulator (21) regulating a heating system (20) which heats the vaporizer crucible (7).

7. Arrangement as claimed in claim 1, **characterized in that** the substrate (4) is located within a vacuum chamber.

8. Arrangement as claimed in claim 1, **characterized in that** the vaporizer crucible (7) is located outside of a vacuum chamber.

9. Arrangement as claimed in claim 1, **characterized in that** the vapor distributor (3) comprises at least one nozzle (24) through which streams vapor onto a measuring instrument (23).

10. Arrangement as claimed in claim 1, **characterized in that** the vapor feed system (1) as well as the crucible (7) are comprised of a material that does not react chemically with the material to be vaporized.

11. Arrangement as claimed in claim 5, **characterized in that** the movement takes place along a rail (30).

12. Arrangement as claimed in claim 1, **characterized in that** a separate chamber (40) is provided for filling or exchanging the vaporizer crucible (7).

13. Arrangement as claimed in claim 12, **characterized in that** the chamber (40) is a glovebox (40).

14. Arrangement as claimed in claim 6, **characterized in that** the regulator (21) is a PID controller.

15. Arrangement as claimed in claim 2, **characterized in that** the linear vapor distributor (3) has several openings, disposed on at least one line, with a diameter of approximately 1 to 4 mm.

16. Arrangement as claimed in claim 11, **characterized in that** the crucible (7) closed by the separating valve (27) can be removed from the rail (30).

17. Arrangement as claimed in claim 15, **characterized in that** the openings are holes.

18. Arrangement as claimed in claim 15, **characterized in that** the openings are slits.

19. Arrangement as claimed in claim 15, **characterized in that** the openings are located more closely to one another in the margin region of the vapor distributor (3).

20. Arrangement as claimed in claim 1, **characterized in that** the substrates are comprised of silicon or glass or synthetic material or metal.

21. Method for the production of coated substrates with the arrangement as claimed in claims 1 to 20.

22. Method for the production of a lithium battery using an arrangement for the coating of a substrate (4) by means of a vapor distributor (3) connectable via an inlet (5) with a vapor crucible (7), wherein between the crucible (7) and inlet (5) at least one valve (13) is disposed, wherein the vaporizer crucible (7) is located in a chamber (12) that can be evacuated or flooded by means of a vacuum valve (11).

## Patentansprüche

1. Anordnung zum Beschichten eines Substrats (4) mittels eines Dampfverteilers (3), der über einen Einlass (5) mit einem Verdampfertiegel (7) zusammengeschaltet werden kann, wobei zwischen dem Tiegel (7) und dem Einlass (5) mindestens ein Ventil (13) angeordnet ist, wobei sich der Verdampfertiegel (7) in einer Kammer (12) befindet, die mittels eines Vakuumventils (11) entleert oder geflutet werden kann, und **gekennzeichnet durch** ein zweites Ventil (27), das mit der Tiegelkammer (12) assoziert ist.

2. Anordnung nach Anspruch 1, **dadurch gekennzeichnet, dass** es sich bei dem Dampfverteiler (3) um einen linearen Dampfverteiler handelt.

3. Anordnung nach Anspruch 1, **dadurch gekennzeichnet, dass** der Verdampfertiegel (7) zum Einlass (5) hin und davon weg bewegt werden kann.

4. Anordnung nach Anspruch 1, **dadurch gekennzeichnet, dass** das zwischen dem Tiegel (7) und dem Einlass (5) vorgesehene Ventil (13) mit dem Einlass (5) verbunden ist.

5. Anordnung nach Anspruch 1, **dadurch gekennzeichnet, dass** das zweite Ventil (27) zusammen mit dem Verdampfertiegel (7) und der Kammer (12) bewegt werden kann.

6. Anordnung nach Anspruch 1, **dadurch gekennzeichnet, dass** ein Messinstrument (23) vorgesehen ist, das die Verdampfungsrate misst, und dass dieses Messinstrument (23) mit einem Regler (21) zusammengeschaltet ist, der ein Heizsystem (20) regelt, das den Verdampfertiegel (7) erwärmt.

7. Anordnung nach Anspruch 1, **dadurch gekennzeichnet, dass** sich das Substrat (4) in einer Vakuumkammer befindet.

8. Anordnung nach Anspruch 1, **dadurch gekennzeichnet, dass** sich der Verdampfertiegel (7) außerhalb einer Vakuumkammer befindet.

9. Anordnung nach Anspruch 1, **dadurch gekennzeichnet, dass** der Dampfverteiler (3) mindestens eine Düse (24) umfasst, durch welche Dampf auf ein Messinstrument (23) strömt.

10. Anordnung nach Anspruch 1, **dadurch gekennzeichnet, dass** das Dampfzuführungssystem (1) sowie der Tiegel (7) aus einem Material bestehen, das mit dem zu verdampfenden Material nicht chemisch reagiert.

11. Anordnung nach Anspruch 5, **dadurch gekennzeichnet, dass** die Bewegung entlang einer Schiene (30) stattfindet.

12. Anordnung nach Anspruch 1, **dadurch gekennzeichnet, dass** eine separate Kammer (40) vorgesehen ist, um den Verdampfertiegel (7) zu füllen oder auszutauschen.

13. Anordnung nach Anspruch 12, **dadurch gekennzeichnet, dass** es sich bei der Kammer (40) um eine Handschuhkammer *(glovebox)* (40) handelt.

14. Anordnung nach Anspruch 6, **dadurch gekennzeichnet, dass** es sich bei dem Regler (21) um einen PID-Regler handelt.

15. Anordnung nach Anspruch 2, **dadurch gekennzeichnet, dass** der lineare Dampfverteiler (3) mehrere auf mindestens einer Linie angeordnete Öffnungen mit einem Durchmesser von ca. 1 bis 4 mm hat.

16. Anordnung nach Anspruch 11, **dadurch gekennzeichnet, dass** der durch das Trennventil (27) verschlossene Tiegel (7) von der Schiene (30) abgenommen werden kann.

17. Anordnung nach Anspruch 15, **dadurch gekennzeichnet, dass** es sich bei den Öffnungen um Löcher handelt.

18. Anordnung nach Anspruch 15, **dadurch gekennzeichnet, dass** es sich bei den Öffnungen um Schlitze handelt.

19. Anordnung nach Anspruch 15, **dadurch gekennzeichnet, dass** sich die Öffnungen im Randbereich des Dampfverteilers (3) näher bei einander befinden.

20. Anordnung nach Anspruch 1, **dadurch gekennzeichnet, dass** die Substrate aus Silicium oder Glas oder Kunststoff oder Metall bestehen.

21. Verfahren zur Herstellung beschichteter Substrate mit der Anordnung nach den Ansprüchen 1 bis 20.

22. Verfahren zur Herstellung einer Lithiumbatterie unter Verwendung einer Anordnung zur Beschichtung eines Substrats (4) mittels eines Dampfverteilers (3), der über einen Einlass (5) mit einem Verdampfertiegel (7) zusammengeschaltet werden kann, wobei zwischen dem Tiegel (7) und dem Einlass (5) mindestens ein Ventil (13) angeordnet ist, wobei sich der Verdampfertiegel (7) in einer Kammer (12) befindet, die mittels eines Vakuumventils (11) entleert oder geflutet werden kann.

## Revendications

1. Agencement pour le revêtement d'un substrat (4) au moyen d'un distributeur de vapeur (3) raccordable via une entrée (5) à un creuset de vaporiseur (7), dans lequel au moins une vanne (13) est disposée entre le creuset (7) et l'entrée (5), dans lequel le creuset de vaporiseur (7) est situé dans une chambre (12) qui peut être évacuée ou inondée au moyen d'une vanne de vide (11), et **caractérisé par** une deuxième vanne (27) qui est associée à la chambre de creuset (12).

2. Agencement tel que revendiqué dans la revendication 1, **caractérisé en ce que** le distributeur de vapeur (3) est un distributeur de vapeur linéaire.

3. Agencement tel que revendiqué dans la revendication 1, **caractérisé en ce que** le creuset de vaporiseur (7) est mobile vers l'entrée (5) et depuis celle-ci.

4. Agencement tel que revendiqué dans la revendication 1, **caractérisé en ce que** la vanne (13) prévue entre le creuset (7) et l'entrée (5) est associée à l'entrée (5).

5. Agencement tel que revendiqué dans la revendication 1, **caractérisé en ce que** la deuxième vanne (27) est mobile avec le creuset de vaporiseur (7) et la chambre (12).

6. Agencement tel que revendiqué dans la revendication 1, **caractérisé en ce qu'**un instrument de mesure (23) est prévu, qui mesure le taux de vaporisation et **en ce que** cet instrument de mesure (23) est raccordé à un régulateur (21) qui régule un système de chauffage (20) qui chauffe le creuset de vaporiseur (7).

7. Agencement tel que revendiqué dans la revendication 1, **caractérisé en ce que** le substrat (4) est situé à l'intérieur d'une chambre de vide.

8. Agencement tel que revendiqué dans la revendication 1, **caractérisé en ce que** le creuset de vaporiseur (7) est situé à l'extérieur d'une chambre de vide.

9. Agencement tel que revendiqué dans la revendication 1, **caractérisé en ce que** le distributeur de vapeur (3) comprend au moins une tubulure (24) à travers laquelle passe de la vapeur vers un instrument de mesure (23).

10. Agencement tel que revendiqué dans la revendication 1, **caractérisé en ce que** le système d'alimentation en vapeur (1) ainsi que le creuset (7) sont constitués d'une matière qui ne réagit pas chimiquement avec la matière à vaporiser.

11. Agencement tel que revendiqué dans la revendication 5, **caractérisé en ce que** le mouvement s'effectue le long d'un rail (30).

12. Agencement tel que revendiqué dans la revendication 1, **caractérisé en ce qu'**une chambre séparée (40) est prévue pour remplir ou échanger le creuset de vaporiseur (7).

13. Agencement tel que revendiqué dans la revendication 12, **caractérisé en ce que** la chambre (40) est une boîte à gants (40).

14. Agencement tel que revendiqué dans la revendication 6, **caractérisé en ce que** le régulateur (21) est un contrôleur PID.

15. Agencement tel que revendiqué dans la revendication 2, **caractérisé en ce que** le distributeur de vapeur linéaire (3) présente plusieurs ouvertures, disposées sur au moins une ligne, avec un diamètre d'approximativement 1 à 4 mm.

16. Agencement tel que revendiqué dans la revendication 11, **caractérisé en ce que** le creuset (7) fermé par la vanne de séparation (27) peut être enlevé du rail (30).

17. Agencement tel que revendiqué dans la revendication 15, **caractérisé en ce que** les ouvertures sont des trous.

18. Agencement tel que revendiqué dans la revendication 15, **caractérisé en ce que** les ouvertures sont des fentes.

19. Agencement tel que revendiqué dans la revendication 15, **caractérisé en ce que** les ouvertures sont situées plus près l'une de l'autre dans la région de bordure du distributeur de vapeur (3).

20. Agencement tel que revendiqué dans la revendication 1, **caractérisé en ce que** les substrats sont constitués de silicone ou de verre ou de matière synthétique ou de métal.

21. Procédé de production de substrats revêtus avec l'agencement tel que revendiqué dans les revendications 1 à 20.

22. Procédé de production d'une batterie au lithium au moyen d'un agencement pour le revêtement d'un substrat (4) au moyen d'un distributeur de vapeur (3) raccordable via une entrée (5) à un creuset de vaporiseur (7), dans lequel au moins une vanne (13) est disposée entre le creuset (7) et l'entrée (5), dans lequel le creuset de vaporiseur (7) est situé dans une chambre (12) qui peut être évacuée ou inondée au moyen d'une vanne de vide (11).
